# EUROPEAN PATENT APPLICATION

(11) **EP 3 951 718 A1**
(43) Date of publication of application: **09.02.2022**
(21) Application number: 19930004.7
(22) Date of filing: 11.09.2019
(51) Int. Cl.: G06T 17/00

(54) **AUTOMATIC HUMAN BODY PARAMETER GENERATION METHOD BASED ON MACHINE LEARNING**

(30) Priority: 17.05.2019 CN 201910414893
(71) Applicant: Shanghai Linctex Digital Technology Co., Ltd., Shanghai 201100 (CN)
(72) Inventor: LUO, Likang, Shanghai 201100 (CN); WANG, Luyuan, Shanghai 201100 (CN); JIN, Xiaogang, Shanghai 201100 (CN); LIU, Chen, Shanghai 201100 (CN); HUANG, Ninghai, Shanghai 201100 (CN); SHAO, Zexi, Shanghai 201100 (CN)
(74) Representative: Huang, Liwei
(86) International application number: PCT/CN2019/105296
(87) International publication number: WO 2020/232917

(57) **Abstract**

The invention discloses an automatic human body parameter generation method based on machine learning. The said automatic human body parameter generation method based on machine learning comprises the following steps:
(1) Initialize a converting program, with accurate human body parameters as the inputs and general body shape descriptions as the outputs. input several groups of accurate human body parameters into the converting program to get different combinations of general body shape descriptions as the training sets for subsequent steps;
(2) Train by using the training sets from Step (1) through machine learning to get mapping relationship between general body shape descriptions and 3D human body model parameters;
(3) By inputing gender, specific height, and weight information, the users answer a series of preset general body shape-related descriptive questions ("yes" or "no"), and utilize the mapping relationship from Step (3) to rapidly output accurate human body parameters in line with the actual situation of the users.

## Description

### Technical field

The invention relates to the field of 3D human body reconstruction technology, in particular to an automatic human body parameter generation method based on machine learning.

### Background technology

During virtual dressing, it is often the case that a 3D human body model in line with the user's body shape shall be generated for the model to wear the garment and test the dressing effect. In most of the current 3D human body reconstruction methods, devices like the depth camera are utilized to scan the bodies of real users, and the 3D human body model is reconstructed based on the information obtained. This method is found with three defects: first, special devices are required to collect the human body information, which increases the device costs; second, the sensors shall be placed in an open and unblocked environment, restricting the site to some extent; third, the users shall pose as instructed to allow for rotational or multi-angle photographing so as to collect human body data, requiring some skills and even becoming an obstacle for some users.

In recent years, the development of machine learning greatly promotes the advancement of all computer science fields, leading to lots of open-sourced 3D model datasets about human bodies. The parameter mapping relationship of people with different body shapes can be obtained by means of machine learning, and it just takes some learning and training costs to efficiently get accurate results in future real applications, providing a new thought to the reconstruction of the 3D human body model.

### Summary of the invention

The invention aims to provide an automatic human body parameter generation method based on machine learning. The simple, efficient, and low-cost method provided by this invention can be utilized to rapidly generate accurate human body parameters close to the user's real body shape after inputing basic information about the user and answering the predefined questions.

An automatic human body parameter generation method based on machine learning, comprising the following steps:
(1) Initialize a converting program, with accurate human body parameters as the inputs and general body shape descriptions as the outputs. input several groups of accurate human body parameters into the said converting program in Step (1) to get different combinations of general body shape descriptions as the training sets for subsequent steps;
(2) Train by using the training sets from Step (1) through machine learning to get mapping relationship between general body shape descriptions and 3D human body model parameters;
(3) By inputing gender, specific height, and weight information, the users answer a series of preset general body shape-related descriptive questions ("yes" or "no"), and utilize the mapping relationship from Step (3) to rapidly output accurate human body parameters in line with the actual situation of the users.

In the said Step (1), the accurate data of the human body's different parts are within a certain range; with male neck shape as an example, the general body shape description is set in the converting program: when the neck circumference inputted is not more than 35cm, the neck shape is "slightly thin"; when falling within 35-40cm, the neck shape is "normal"; when greater than 40cm, the neck shape is "slightly thick". Likewise, with male waist shape as an example, the following general body shape description is presented in the converting program: when the waist-to-hip ratio is not more than 0.8, the waist shape is "sunken"; when greater than 0.8 and not more than 0.87, the waist shape is "straight"; when greater than 0.87 and not more than 0.93, the waist shape is "generally protruding". In this way, all human body parameters inputted can be converted to get a group of general body shape descriptions about the human body model, namely, a group of answers to the body shape-related descriptive questions.

Further, for a certain group of human body measurements, a group of general human body descriptions can be outputted with the help of the converting program, such as "normal" neck shape, chest shape with "severely muscular", "regular" shoulder shape, "straight" back, "slightly short" arm length, "generally protruding" waist shape, "flat" abdomen shape, "inverted triangular" body shape, "medium-sized" skeleton, and "normal" leg shape.

Further, when the model is being used in real life, the user shall answer a group of predefined body shape-related descriptive questions to get general body shape descriptions about the user.

In the said Step (3), every 3D human body model is equipped with a group of human body measurements; to get a 3D human body model in line with the user's real body shape, general body shape descriptions given by the user shall be correlated with human body measurements of corresponding body shapes, which are called mapping relationship.

### Description of Figures

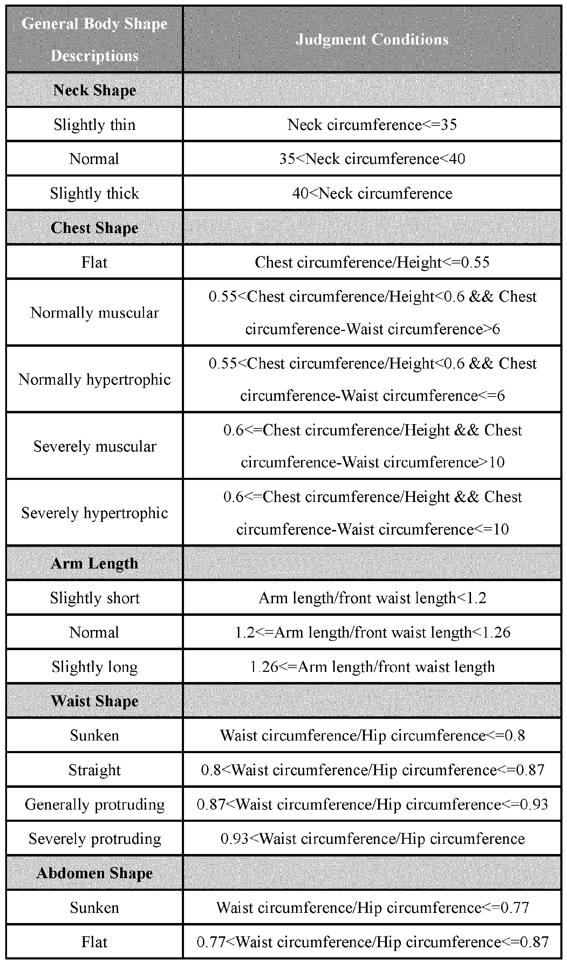

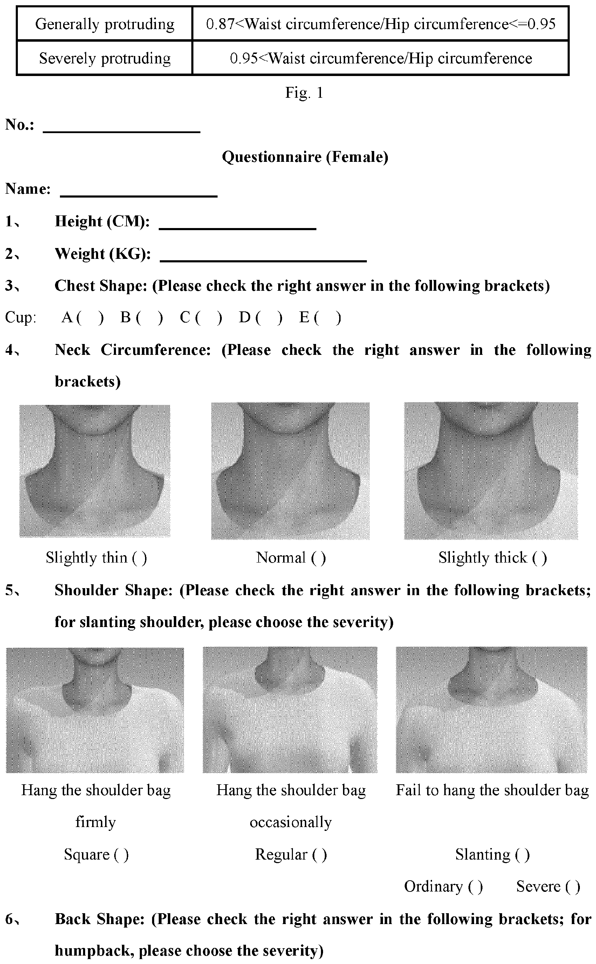

Fig. 1 presents some general descriptions and judgment conditions in the converting program;

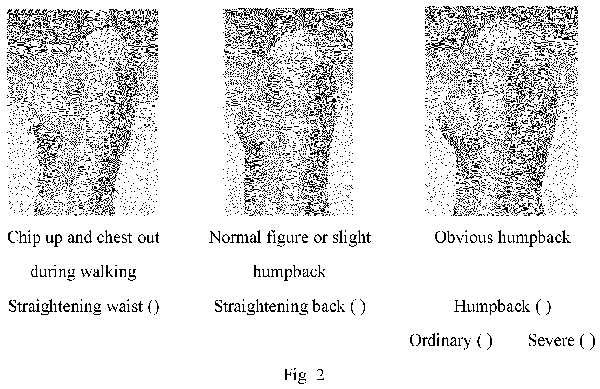

Fig. 2 presents some predefined questions (about females) on general human body descriptions provided in this invention;

### Detailed description of the invention embodiments

Next, the technical solution in this invention will be further detailed in conjunction with figures and embodiments.
(1) Initialize a converting program, with accurate human body parameters as the inputs and general body shape descriptions as the outputs; input several groups of accurate human body parameters into the converting program to get different combinations of general body shape descriptions as the training sets for subsequent steps;
(2) Train by using the training sets from Step (1) through machine learning to get mapping relationship between general body shape descriptions and 3D human body model parameters;
(3) By inputing gender, specific height, and weight information, the users answer a series of preset general body shape-related descriptive questions ("yes" or "no"), and utilize the mapping relationship from Step (3) to rapidly output accurate human body parameters in line with the actual situation of the users.

In the said Step (1), the accurate data of the human body's different parts are within a certain range; with male neck shape as an example, the general body shape description is set in the converting program: when the neck circumference inputted is not more than 35cm, the neck shape is "slightly thin"; when falling within 35-40cm, the neck shape is "normal"; when greater than 40cm, the neck shape is "slightly thick". Likewise, with male waist shape as an example, the following general body shape description is presented in the converting program: when the waist-to-hip ratio is not more than 0.8, the waist shape is "sunken"; when greater than 0.8 and not more than 0.87, the waist shape is "straight"; when greater than 0.87 and not more than 0.93, the waist shape is "generally protruding". In this way, all human body parameters inputted can be converted to get a group of general body shape descriptions about the human body model, namely, a group of answers to the body shape-related descriptive questions.

(1-1) For a certain group of human body measurements, a group of general human body descriptions can be outputted with the help of the converting program, such as "normal" neck shape, chest shape with "severely muscular", "regular" shoulder shape, "straight" back, "slightly short" arm length, "generally protruding" waist shape, "flat" abdomen shape, "inverted triangular" body shape, "medium-sized" skeleton, and "normal" leg shape.

(1-2) When the model is being used in real life, the user shall answer a group of predefined body shape-related descriptive questions to get general body shape descriptions about the user.

In the said Step (3), every 3D human body model is equipped with a group of human body measurements; to get a 3D human body model in line with the user's real body shape, general body shape descriptions given by the user shall be correlated with human body measurements of corresponding body shapes, which are called mapping relationship.

Above are detailed descriptions about this invention, but the embodiments of this invention are not limited to the above ones, and other alterations, replacements, combinations, and simplifications made under the guidance of the core idea of this invention shall also be included in the protection range of this invention.

## Claims

1. A method of automatically generating human-body parameters on basis of machine learning, comprising following steps:
(1) initializing a converting program, the inputs of which are accurate human-body parameters and the outputs of which are general body-shape descriptions; inputting several groups of accurate human-body parameters into the converting program, so as to obtain various combinations of general body-shape descriptions, which are to be used as training sets for subsequent steps;
(2) carrying out a training through machine learning by using the training sets obtained from Step (1), to obtain a mapping relationship between general body-shape descriptions and parameters of a 3D human body model;
(3) a user inputting gender, height, and weight information, answering a series of preset general descriptive questions about body shape ("yes" or "no"), and using the mapping relationship obtained from Step (3), to rapidly output accurate human-body parameters which are in line with an actual human body of the user.

2. The said converting program in Claim 1, **characterized in that** accurate data of different parts in a human body are within a certain range; with a neck shape of a male as an example, the general body shape descriptions are set in the converting program as follows: when an inputted neck circumference is not more than 35cm, the neck shape is "slightly thin"; when from 35cm to40cm, the neck shape is "normal"; when greater than 40cm, the neck shape is "slightly thick". Likewise, with a waist shape of a male as an example, the general body-shape descriptions are set in the converting program as follows: when a waist-to-hip ratio is not more than 0.8, the waist shape is "sunken"; when greater than 0.8 and not more than 0.87, the waist shape is "straight"; when greater than 0.87 and not more than 0.93, the waist shape is "generally protruding". In this way, all human-body parameters inputted can be converted to get a group of general body-shape descriptions about a human body model, namely, a group of answers to the descriptive questions about body shape.

3. A group of the said general body-shape descriptions in Claim 2, **characterized in that** for a certain group of human body measurements, a group of general human body descriptions can be outputted with the help of the converting program, such as a "normal" neck shape, a chest shape with "severely muscular", a "regular" shoulder shape, a "straight" back, a "slightly short" arm length, a "generally protruding" waist shape, a "flat" abdomen shape, an "inverted triangular" body shape, a "medium-sized" skeleton, and a "normal" leg shape.

4. The said descriptive questions about body shape in Claim 2, **characterized in that** when being used in real life, the user shall answer a group of predefined body shape-related descriptive questions to get general body shape descriptions about the user.

5. The said mapping relationship in Claim 1, **characterized in that** every 3D human body model is equipped with a group of human body measurement data; to get a 3D human body model in line with the user's real body shape, general body-shape descriptions given by the user shall be correlated with human body measurement data of a corresponding body shape, which are called the mapping relationship.
